Europäisches Patentamt

European Patent Office

Office européen des brevets

(19)

(11) EP 0 612 156 B1

(12) EUROPÄISCHE PATENTSCHRIFT

(45) Veröffentlichungstag und Bekanntmachung des Hinweises auf die Patenterteilung:
09.10.1996 Patentblatt 1996/41

(51) Int Cl.6: H03M 7/42

(21) Anmeldenummer: 94106503.9

(22) Anmeldetag: 12.04.1990

(54) Digitales Codierverfahren

Digital coding method

Procédé de codage numérique

(84) Benannte Vertragsstaaten:
AT BE CH DE DK ES FR GB GR IT LI LU NL SE

(30) Priorität: 17.04.1989 DE 3912605

(43) Veröffentlichungstag der Anmeldung:
24.08.1994 Patentblatt 1994/34

(60) Teilanmeldung: 96102114.4

(62) Anmeldenummer der früheren Anmeldung nach Art. 76 EPÜ: 90107082.1

(73) Patentinhaber: FRAUNHOFER-GESELLSCHAFT ZUR FÖRDERUNG DER ANGEWANDTEN FORSCHUNG E.V.
80636 München (DE)

(72) Erfinder:
• Grill, Bernhard
  D-91207 Lauf (DE)

• Sporer, Thomas
  D-90766 Fürth (DE)
• Kürten, Bernd
  D-90587 Obermichelbach (DE)
• Seitzer, Dieter
  D-91054 Erlangen (DE)
• Eberlein, Ernst
  D-91091 Grossenseebach (DE)
• Brandenburg, Karl-Heinz
  D-91056 Erlangen (DE)

(74) Vertreter: Münich, Wilhelm, Dr.
Kanzlei Münich, Steinmann, Schiller
Wilhelm-Mayr-Str. 11
80689 München (DE)

(56) Entgegenhaltungen:
EP-A- 0 166 607          WO-A-88/01811
US-A- 3 675 211          US-A- 3 717 851
US-A- 4 475 174          US-A- 4 813 056
US-A- 4 816 914

**Beschreibung**

Die Erfindung bezieht sich auf ein digitales Codierverfahren für die Übertragung und/oder Speicherung von akustischen Signalen und insbesondere von Musiksignalen gemäß dem Oberbegriff des Patentanspruchs 1 sowie auf ein Decodierverfahren.

Verfahren gemäß dem Oberbegriff des Patentanspruchs 1 sind beispielsweise aus der DE-PS 33 10 480 oder aus der WO 88/ 01811 bekannt. Auf die genannten Druckschriften wird im übrigen zur Erläuterung aller hier nicht näher beschriebenen Begriffe ausdrücklich Bezug genommen.

Insbesondere bezieht sich die Erfindung auf das in der WO 88/01811 erstmals vorgeschlagene OCF-Verfahren. Dieses bekannte Verfahren vermag zwar die Kodiergeschwindigkeit zu erhöhen, doch sind den in der vorgenannten Druckschrift beschriebenen Maßnahmen Grenzen gesetzt, die im Lichte des stetig zunehmenden Bedarfes an Informationsübertragung und den damit verbundenen begrenzten Datenübertragungskanälen derart an Bedeutung gewonnen haben, so daß die bekannte Technik dem Wunsch nach Reduzierung auf die relevanten zu übertragenen Daten nicht gerecht wird.

Aus der Druckschrift US-A 3 675 211 ist ein digitales Codierverfahren bekannt, das die Verwendung einer Entropiekodierung unter Zugrundelegung einer modifizierten Huffman-Codierung vorsieht. Zwar kann mit dieser Lehre eine schnellere Codierung bei Verbesserung der Coderedundanz vorgenommen werden, doch gilt es auch diese vorgeschlagenen Maßnahmen zu verbessern.

Der Erfindung liegt die Aufgabe zugrunde, digitale Codierverfahren und insbesondere das aus der WO 88/01811 bekannte OCF-Verfahren derart weiterzubilden, daß bereits bei Datenraten von cirka 2 bit/ATW eine Codierung von Musik mit einer der Compact-Disc vergleichbaren Qualität und bei Datenraten von 1,5 bit/ATW die Codierung von Musik mit einer Qualität von guten UKW-Rundfunksendungen möglich ist.

Eine erfindungsgemäße Lösung dieser Aufgabe ist mit ihren Weiterbildungen und Ausgestaltungen in den Patentansprüchen angegeben.

Die Erfindung wird nachstehend anhand der Zeichnung näher beschrieben, in der zeigen:

Fig. 1    ein Spektrum mit ausgeprägtem Maximum,
Fig. 2    Codewörter in einem festen Raster,
Fig. 3    die Anordnung wichtiger Nachrichtenteile in einem festen Raster,
Fig. 4    schematisch den als "Bitsparkasse" dienenden Ringpuffer, und
Fig. 5    die Häufigkeitsverteilung des Spektrums.

Bei digitalen Codierverfahren für die Übertragung und/oder Speicherung von akustischen Signalen und insbesondere von Musiksignalen wird im allgemeinen so vorgegangen, daß zunächst die Abtastwerte des akustischen Signals in eine Folge von zweiten Abtastwerten transformiert werden, die die spektrale Zusammensetzung des akustischen Signals wiedergeben. Diese Folge von zweiten Abtastwerten wird dann entsprechend den Anforderungen mit unterschiedlicher Genauigkeit quantisiert und teilweise oder ganz mittels eines Optimalcodierers codiert. Bei der Wiedergabe erfolgt eine entsprechende Decodierung und Rücktransformation.

Die Umsetzung der Abtastwerte des akustischen Signals in eine Folge zweiter Abtastwerte kann dabei mittels einer Transformation oder einer Filterbank erfolgen, wobei gegebenenfalls das Ausgangssignal der Filterbank "unter"-abgetastet wird, so daß eine Blockbildung wie bei einer Transformation entsteht.

Erfindungsgemäß wird ein digitales Codierverfahren für die Übertragung und/oder Speicherung von akustischen Signalen und insbesondere von Musiksignalen, bei dem Abtastwerte des akustischen Signals mittels einer Transformation oder einer Filterbank in eine Folge von zweiten Abtastwerten transformiert werden, die die spektrale Zusammensetzung des akustischen Signals wiedergeben, und diese Folge von zweiten Abtastwerten entsprechend den Anforderungen mit unterschiedlicher Genauigkeit quantisiert und teilweise oder ganz mittels eines Codierers codiert wird, bei dem die Auftrittswahrscheinlichkeit des quantisierten Spektralkoeffizienten mit der Länge des Codes derart korreliert ist, daß das Codewort umso kürzer ist, je häufiger der Spektralkoeffizient auftritt, und bei dem bei der Wiedergabe eine entsprechende Decodierung und Rücktransformation erfolgt, derart weitergebildet, daß zur Reduzierung der Tabellengröße des Codierers entweder mehreren Elementen der Folge oder einem Wertebereich ein Codewort sowie gegebenenfalls ein Zusatzcode zugeordnet werden, und daß n Spektralkoeffizienten mit n≥2 zu einem n-Tupel zusammengefaßt und gemeinsam durch Angabe eines Codewortes codiert werden.

Vorzugsweise arbeiten derartige Codierer unter Zugrundelegung des Huffmancodes (Anspruch 3).

Ferner werden erfindungsgemäß zur Reduzierung der Tabellengröße des Codierers entweder mehreren Elementen der Folge oder einem Wertebereich ein Codewort sowie gegebenenfalls ein Zusatzcode zugeordnet.

Die gemeinsame Codierung von Spektralkoeffizienten kann dabei auf verschiedene Arten erfolgen: Beispielsweise kann sie im Frequenzraum oder in der Zeitachse vorgenommen werden, wobei dieselben Koeffizienten aus aufeinanderfolgenden Blöcken gemeinsam codiert werden.

EP 0 612 156 B1

Ferner kann einem Wertebereich in einer Art Grobquantisierung ein Codewort zugeordnet werden. Auch ist eine direkte Codierung eines Teilbereichs möglich, wobei der Rest des Wertebereichs mit einer gesonderten Kennung versehen und zusätzlich der Offset zur Wertebereichsgrenze codiert wird.

Der Code wird dabei im allgemeinen einer Tabelle entnommen, deren Länge der Anzahl der Codewörter entspricht. Falls eine große Anzahl von Codewörtern mit einer Wortlänge, die größer als die durchschnittliche Wortlänge ist, eine ähnliche Wortlänge besitzt, können alle diese Codewörter mit einem geringen Verlust an Codiereffektivität durch eine gemeinsame Kennung und einen nachfolgenden besonderen Code, der dem Anwendungsfall angepaßt ist, beschrieben werden. Dieser Code kann beispielsweise ein PCM-Code (pulscode Modulation) sein). Dieses Verfahren ist insbesondere dann effizient, wenn nur wenige Werte eine große Auftrittswahrscheinlichkeit besitzen, wie es z.B. bei der Codierung von Musik in Spektraldarstellung der Fall ist.

Im folgenden soll dies an einem Beispiel erläutert werden. Dabei sei folgende Wahrscheinlichkeitsverteilung gegeben:

| Wert | Wahrscheinlichkeit |
|---|---|
| 0 | 50% |
| 1 | 30% |
| 2 | 15% |
| 3...15 | zusammen 5%, d.h. je 0,38 % |

Die Entropie, d.h. die kürzest mögliche mittlere Codelänge beträgt hier 1,83275 bit.

Bei einem derartigen Anwendungsfall ist es von Vorteil, einen Huffmancode zu bestimmen, der die Werte 0,1,2 und eine Kennung (im folgenden mit ESC bezeichnet), in der die Werte 3 bis 15 codiert werden, beinhaltet.

| Wert | Huffmancode mit ESC | Huffmancode ohne ESC |
|---|---|---|
| 0 | 0 | 0 |
| 1 | 10 | 10 |
| 2 | 110 | 110 |
| 3 | 111+0011 | 111101 |
| 4 | 111+0100 | 111110 |
| 5 | 111+0101 | 111111 |
| 6 | 111+0110 | 1110000 |
| 7 | 111+0111 | 1110001 |
| 8 | 111+1000 | 1110010 |
| 9 | 111+1001 | 1110011 |
| 10 | 111+1010 | 1110100 |
| 11 | 111+1011 | 1110101 |
| 12 | 111+1100 | 1110110 |
| 13 | 111+1101 | 1110111 |
| 14 | 111+1110 | 1111000 |
| 15 | 111+0111 | 1111001 |

Bei reiner Huffman-Codierung erhält man eine mittlere Codelänge von 1,89 bit, bei einer Codierung mit ESC dagegen eine mittlere Codelänge von 1,9 bit. Die Codeeffizienz wird bei ESC-Codierung zwar geringfügig schlechter, die Tabellengröße für den Coder und den Decoder aber um den Faktor 4 kleiner, so daß die Geschwindigkeit für den Codier- und Decodiervorgang beträchtlich ansteigt.

Verwendet man als Code nach dem ESC-Wert einen modifizierten PCM-Code, so lassen sich ohne Veränderung der mittleren Codelänge sogar die Werte bis 18 codieren.

Huffmancode mit ESC
0
10
110
111+0000
111+0001

3

(fortgesetzt)

Huffmancode mit ESC
111+0010
111+0011
111+0100
111+0101
111+0110
111+0111
111+1000
111+1001
111+1010
111+1011
111+1100
111+1101
111+1110
111+0111

Optimalcoder, die jedem Spektralwert ein Codewort verschiedener Länge zuweisen, sind nur in Ausnahmefällen "optimal im Sinne der Informationstheorie". Eine weitere Reduktion der Code-Redundanz kann durch die erfindungsgemäße Codierung dadurch erreicht werden, daß wenigstens einem Paar von Spektralwerten ein Codewort zugeordnet wird. Die Redundanzverminderung ergibt sich zum einen daraus, daß die beiden gemeinsam codierten Spektralwerte statistisch nicht unabhängig sind, zum anderen aus der Tatsache, daß bei der Codierung von Paaren von Werten eine feinere Anpassung des Codebuchs bzw. der Codetabelle an die Signalstatistik erfolgen kann.

Dies soll im folgenden an einem Beispiel erläutert werden:

Zunächst sei ein Entropiecoder (Optimalcoder) betrachtet, der Einzelwerten einzelne Codeworte zuordnet:

| Datenwort | Häufigkeit | Codewort | Häufigkeit $*$ Codelänge |
|---|---|---|---|
| 0 | 70 % | 0 | 0,7 |
| 1 | 30 % | 1 | 0,3 |

Es ergibt sich eine mittlere Codewortlänge von 1.

Bei Betrachtung der Wahrscheinlichkeiten von Paaren von Abtastwerten ergibt sich folgender Optimalcodierer:

| Datenwort | Häufigkeit | Codewort | Häufigkeit $*$ Codelänge |
|---|---|---|---|
| 00 | 50% | 0 | 0,50 $*$ 1 |
| 01 | 20% | 10 | 0,20 $*$ 2 |
| 10 | 20% | 110 | 0,20 $*$ 3 |
| 11 | 10% | 111 | 0,10 $*$ 3 |
| | | | $= 1,8$ |

Die mittlere Codewortlänge pro Einzelwert ergibt sich aus der Summe der Terme "Häufigkeit * Codewortlänge", geteilt durch 2 (wegen der Codierung von Paaren von Werten). Sie ist im Beispiel 0,9. Dies ist weniger, als bei der Codierung von Einzelwerten bei Annahme derselben Signalstatistik erreichbar ist. Die Codierung von Paaren von Spektralwerten geschieht z.B. dadurch, daß der jeweils erste Spektralwert als Zeilennummer und der zweite Werte eins Paars als Spaltennummer verwendet wird, um in einer Codetabelle das jeweilige Codewort zu adressieren.

Vergrößert man die Anzahl der zusammen codierten Werte weiter, so ergibt sich im Mittel eine kleinere Codewortlänge, z.B. für 4-Tupel:

| Datenwort | Häufigkeit | Codewort | Häufigkeit$*$Codelänge |
|---|---|---|---|
| 0000 | 25 % | 10 | 0,25 $*$ 2$=$ 0,5 |
| 0001 | 10 % | 000 | 0,1 $*$ 3 $=$ 0,3 |
| 0010 | 10 % | 010 | 0,1 $*$ 3 $=$ 0,3 |

(fortgesetzt)

| Datenwort | Häufigkeit | Codewort | Häufigkeit∗Codelänge |
|-----------|-----------|----------|----------------------|
| 0011 | 5 % | 11101 | $0,05 * 5 = 0,2$ |
| 0100 | 10 % | 011 | $0,1 * 3 = 0,3$ |
| 0101 | 4 % | 11100 | $0,04 * 5 = 0,2$ |
| 0110 | 4 % | 11001 | $0,04 * 5 = 0,2$ |
| 0111 | 2 % | 00100 | $0,02 * 5 = 0,1$ |
| 1000 | 10 % | 1111 | $0,1 * 4 = 0,4$ |
| 1001 | 4 % | 11011 | $0,04 * 5 = 0,2$ |
| 1010 | 4 % | 11010 | $0,04 * 5 = 0,2$ |
| 1011 | 2 % | 110001 | $0,02 * 6 = 0,12$ |
| 1100 | 5 % | 0011 | $0,05 * 4 = 0,2$ |
| 1101 | 2 % | 110000 | $0,02 * 6 = 0,12$ |
| 1110 | 2 % | 001011 | $0,02 * 6 = 0,12$ |
| 1111 | 1 % | 001010 | $0,01 * 6 = 0,06$ |
| | | | $\overline{\overline{3,57}}$ |

Die mittlere Codelänge beträgt also im Beispiel 3,57/4 = 0,89 bit.

Ferner ist es auch möglich, eine gemeinsame Codierung dadurch auszuführen, daß Spektralkoeffizienten gleicher Nummer aus aufeinanderfolgenden Blöcken zusammengefaßt und gemeinsam codiert werden. Dies soll im folgenden an einem Beispiel erläutert werden, bei dem zur Vereinfachung zwei Datenblöcke gemeinsam codiert werden; auf die gleiche Weise können aber auch mehr Datenblöcke zusammengefaßt werden:

Es seien x(1), x(2),..., x(n) die Frequenzkoeffizienten eines Blockes, y(1), y(2),..., y(n) die des darauf folgenden Blockes.

1) Die zu codierenden Spektralwerte zweier aufeinanderfolgender Datenblöcke werden zusammen codiert. Dazu wird aus jedem der beiden Blöcke der quantisierte Spektralwert mit der gleichen Nummer genommen und dieses Paar codiert, d.h. zeitlich aufeinanderfolgende Werte der gleichen Frequenz werden zusammen codiert. Die Korrelation zwischen diesen ist bei quasistationären Signalen sehr groß, d.h. ihr Betrag variiert nur wenig. Die dazugehörige Quantisiererinformation ist für beide Datenblöcke wegen der gemeinsamen Codierung nur einmal erforderlich.

Es werden die Paare (x(1) y(1), (x(2) ),..., (x(n) y (n) ) zusammen codiert.

2) Die Beträge zweier aufeinander folgender Spektralwerte eines Blockes sind bei "glatten" Spektren miteinander korreliert. Für solche Signale ist es sinnvoll zwei Spektralwerte eines Blocks zusammen zu codieren.

Es werden die Paare (x(1) x(2) ), (x(3)x(4) ),..., (x(n-1)x(n) ) zusammen codiert. Abhängig von der Transformation sind auch andere Zusammenfassungen von Werten sinnvoll.

3) Die Umschaltung zwischen 1) und 2) kann zum Beispiel durch ein Kennbit übertragen werden.

Für mehr als zwei gemeinsam codierte Werte können beide Möglichkeiten kombiniert werden: Für 4-Tupel sind z.B. folgende Möglichkeiten sinnvoll:

a) je ein Wert aus vier aufeinanderfolgenden Blöcken
b) je zwei Werte aus zwei aufeinanderfolgenden Blöcken
c) vier Werte aus einem Block

Bei den Fällen a) und b) kann man Zusatzinformation einsparen.

Selbstverständlich ist es nicht nur möglich, daß die Codierung durch Bildung von Paaren oder n-Tupeln von je einem Spektralwert jedes Datenblocks geschieht oder daß die Codierung durch Bildung von n-Tupeln von mehr als einem Spektralwert jedes Datenblocks erfolgt, sondern es ist auch möglich, daß zur Bildung der Paare oder n-Tupel von Spektralwerten zwischen Paaren oder n-Tupeln von aufeinanderfolgenden Datenblöcken und Paaren oder n-Tupeln von in der Zählung nach Frequenzwerten aufeinanderfolgenden Spektralwerten umgeschaltet wird.

Ferner werden Zusatzinformationen übertragen:

Im OCF-Verfahren, das in der einleitend genannten WO 88/ 01811 beschrieben ist, werden getrennte Werte für einen Faktor der Pegelsteuerung, die Anzahl der in der inneren Schleife erfolgten Iterationen sowie ein Maß für die spektrale Ungleichverteilung (spectral flatness measure sfm) vom Coder zum Decoder übertragen. Erfindungsgemäß wird aus diesen Werten ein gemeinsamer "Gesamtverstärkungsfaktor" ermittelt und zum Empfänger übertragen. Die Berechnung des Gesamtverstärkungsfaktors erfolgt, indem alle Einzelwerte als Exponenten eines bestimmten Zahlenwertes ausgedrückt und die Faktoren zueinander addiert werden.

Dies soll im folgenden anhand eines Beispiels erläutert werden:
Es seien folgende Verstärkungsoperationen mit dem Signal möglich (a,b,c sind ganze Zahlen):

1) Pegelanpassung: Verstärkungsstufen mit $2^a$

2) Quantisierung:

a) Startwert für Quantisierer in Stufen zu $(\sqrt[4]{2})^c = 1{,}682^b$
b) Vergröberung des Quantisierers in Stufen zu $(\sqrt[4]{2})^c = 1{,}189^c$

Die Quantisierung entspricht einer Division, d.h. einer Abschwächung. Deshalb müssen so gebildete Faktoren negativ genommen werden.
Der gemeinsame Faktor dafür beträgt also $f = \sqrt[4]{2}$.

zu 1)     $f^{4a} = 2^a$
zu 2a)    $f^{3b} = (\sqrt[4]{8})^b$
zu 2b)    $f^c = (\sqrt[4]{2})^c$

Der Gesamtverstärkungsfaktor beträgt damit $f^{4a-3b-c}$, nur der ganzzahlige Exponent wird zu Decoder übertragen. Die Anzahl der nötigen Bit ist durch die Wortlänge der Eingangsdaten (i.a. 16 bit) und die Transformationslänge (ergibt maximale Dynamik) bestimmt.
Weiterhin ist es möglich, der Zusatzinformation eine variable Datenrate zuzuweisen:
Die Korrekturfaktoren, mit denen die Einhaltung der erlaubten Störung erreicht wird, müssen als zusätzliche Pegelinformationen je Frequenzgruppe zum Empfänger übertragen werden. Erfindungsgemäß wird eine Reduktion der mittleren dazu notwendigen Datenrate dadurch erreicht, daß in einem Steuerwort die Länge der folgenden Datenworte codiert wird und jeweils nur die zur Übertragung notwendige Wortlänge verwendet wird. Dies soll im folgenden ebenfalls an einem Beispiel erläutert werden:

| Annahmen: | Zahl der Frequenzgruppen: | 3 |
|---|---|---|
| | maximale Zahl der Iterationen | 8 |

Übertragen wird die Anzahl der Verstärkungen pro Frequenzgruppe. Ohne die variable Datenrate der Zusatzinformation wären dazu 3*3 = 9 bit notwendig. Es werde (im Beispiel) die maximale Zahl der Verstärkungen folgendermaßen verschlüsselt:

| keine Verstärkung | 0 |
|---|---|
| höchstens eine Verstärkung | 1 |
| höchstens drei Verstärkungen | 2 |
| höchstens sieben Verstärkungen | 3 |

Das jeweilige Codewort gibt direkt die Zahl der Bits an, die notwendig sind, um den maximalen Verstärkungswert zu codieren.
Das Ergebnis der psychoakustischen Iterationsschleife sei im Beispiel (0 0 2) d.h. die Frequenzgruppe 3 wurde zweimal verstärkt, die anderen Frequenzgruppen nicht. Dies kann mit folgender Bitfolge codiert werden:
10 00 00 10, also mit insgesamt 8 bit.
Vorzugsweise wird ebenfalls in an sich bekannter Weise ein Codierer verwendet, der nach einem sogenannten Huffman-Code arbeitet. Erfindungsgemäß werden nunmehr jedoch n-Codetabellen mit n≥1 und mit unterschiedlicher Länge verwendet, die dem jeweils zu codierenden akustischen Signal angepaßt sind. Zusammen mit den codierten Werten wird die Nummer der verwendeten Codetabelle übertragen bzw. gespeichert.
Die mittlere Codelänge eines Huffmancodes hängt nämlich von der Anzahl der verschiedenen Zeichen im Code ab. Deshalb ist es sinnvoll, einen Huffmancode zu wählen, der nicht mehr als die nötige Anzahl an Werten enthält. Wählt man als Auswahlkriterium für die Codetabelle den maximal zu codierenden Wert, so können alle aktuell vorkommenden Werte codiert werden.
Hat man mehrere Codebücher bzw. Codetabellen zur Verfügung, so kann man anhand der zu codierenden Werte die beste Tabelle auswählen und als Zusatz information die Codetabellen-Nummer übertragen. Eine Vorauswahl unter den Codetabellen kann über den maximal zu codierenden Wert geschehen.
Nur zur Ergänzung sei angefügt, daß beispielsweise sehr rauhe Spektren, wie sie von Blech-Blasinstrumenten erzeugt werden, eine andere Statistik, bei der kleine Werte häufiger vorkommen, als glatte Spektren haben, wie sie beispielsweise von Streichinstrumenten oder Holzblasinstrumenten erzeugt werden.

Im Anspruch 10 ist eine Weiterbildung gekennzeichnet, bei der zusätzlich oder anstelle der vorstehend genannten Zuordnung von verschiedenen Tabellen unterschiedlichen spektralen Bereichen unterschiedliche Codetabellen zugeordnet werden. Bei Spektren mit einem ausgeprägten Maximum bringt es nämlich einen Gewinn, dieses in einzelne Bereiche zu teilen und für jeden Teilabschnitt einen optimalen Huffmancode zu wählen.

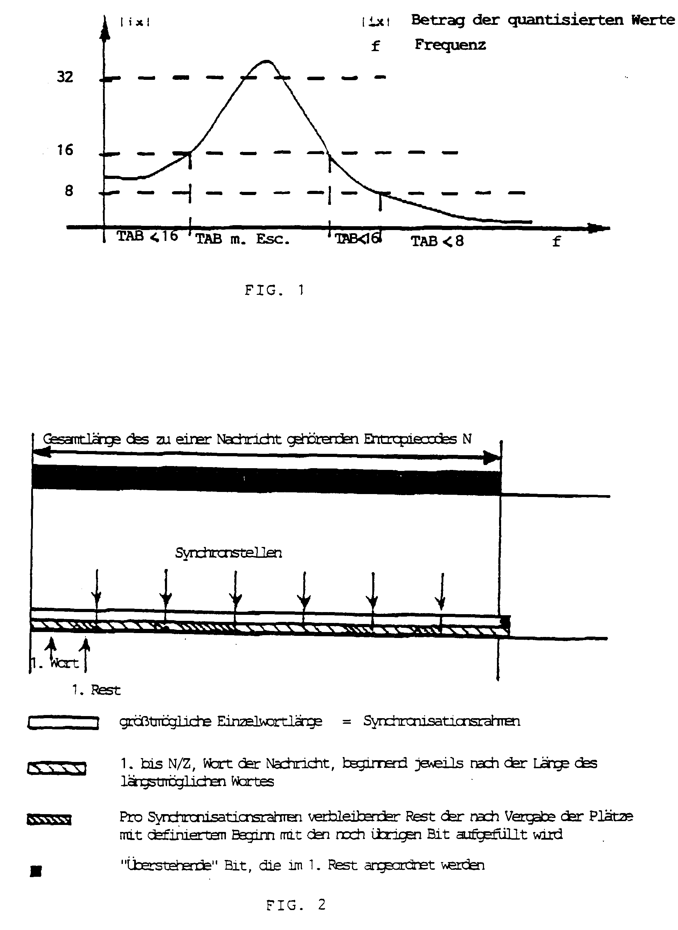

Figur 1 zeigt ein derartiges Spektrum, bei dem sich das Maximum des Spektrums etwa in der Mitte des Spektralbereichs befindet. Hier kann man beispielsweise den Bereich in vier Bereiche teilen:

Im ersten Bereich wird ein Huffmancode mit 16 Werten, im zweiten ein Code mit mehr als 32 Werten, im dritten wiederum ein Code mit 16 Werten und im vierten Bereich ein Code mit 8 Werten verwendet. Dabei ist es bevorzugt, wenn bei der Codetabelle mit mehr als 32 Werten eine Tabelle gemäß Anspruch 1 verwendet wird, bei der Codewörter mit größerer Wortlänge als die durchschnittliche Wortlänge durch eine gemeinsame Kennung und einen nachfolgenden PCM-Code beschrieben werden. Dies ist in Figur 1 durch "TAB mit ESC" bezeichnet.

Die Huffman-Codes werden bei dem bezeigten Beispiel nach dem Maximum der Abschnitte ausgewählt, wobei Codes jeweils für 2,4,8 usw. Werte zur Verfügung stehen. Ohne diese Aufteilung müßte der Code für mehr als 32 Werte auf das gesamte Spektrum Anwendung finden, so daß die benötigte bitzahl für den Block deutlich höher wäre.

Als Zusatz information müssen die Aufteilungspunkte und die Codetabellennummer für jeden Abschnitt übertragen werden.

Die Auswahl des Huffmancodes für jeden Abschnitt kann insbesondere nach den im Anspruch 5 angegebenen Überlegungen erfolgen.

Im Anspruch 11 ist eine vorteilhafte Möglichkeit der Decodierung der bereits genannten Huffmancodes angegeben: Hierzu wird der Baum, der sich bei der Erstellung des Codes ergibt, nachgebildet. Wegen der Bedingung, daß kein Codewort der Anfang eines weiteren Codewortes sein kann, ergibt sich vom "Stamm" ausgehend nur ein möglicher Weg zum zugehörigen Codewort. Um zum Codewort zu gelangen wird, von vorne beginnend, jeweils ein Bit des Codewortes benützt, um bei Verzweigungen im Baum den Weg festzulegen. Die praktische Realisierung erfolgt mittels einer Tabelle von Adresspaaren, die immer vom ersten Paar beginnend abgearbeitet wird. Der erste Wert des Paares enthält dabei jeweils die Adresse der nächsten Verzweigung, die im Falle einer "0" im zu dekodierenden Wert anzuspringen ist, der zweite Wert die Adresse der Verzweigung im Falle einer "1". Jede Adresse wird als solche markiert. Gelangt man zu einem Tabellenwert ohne diese Markierung, so ist ein Codewort erreicht. Der Tabellenwert entspricht in diesem Fall dem zu dekodierenden Wert. Das nächste folgende zu dekodierende Bit ist folglich das erste Bit des folgenden Codewortes. Mit diesem beginnend erfolgt ein erneutes Durchlaufen der Tabelle vom ersten Adresspaar an.

Im folgenden soll hierfür ein Beispiel erläutert werden:

| Wert | Huffmancode |
|------|-------------|
| 0 | 00 |
| 1 | 01 |
| 2 | 100 |
| 3 | 101 |
| 4 | 1100 |
| 5 | 1101 |
| 6 | 1110 |
| 7 | 1111 |

Codebaum:

Dekodiertabelle:

| &0 | &1 | &2 | &3 | &4 | &5 | &6 | &7 |
|------|---------|------|------|---------|---------|------|------|
| &1/&4 | &2/&3 | 0/-- | 1/-- | &5/&8 | &6/&7 | 2/-- | 3/-- |
| &8 | &9 | &10 | &11 | &12 | &13 | &14 | |
| &9/&12 | &10/&11 | 4/-- | 5/-- | &13/&14 | 6/-- | 7/-- | |

Das Zeichen & kennzeichnet eine Adresse.

Dekodierbeispiel : 1 1 0 1 = 5

| &0 | 1 | ==> | &4 |
| &4 | 1 | ==> | &8 |
| &8 | 0 | ==> | &9 |
| &9 | · 1 | ==> | &11 |
| &11 | | ==> | keine Adresse |
| | | ==> | dek. Wert = 5 |

Im Fall, daß der Huffmancode für Wertepaare erstellt wurde, kann am zweiten, im obigen Beispiel freien Tabellenplatz, der zugehörige zweite Wert untergebracht werden. Sinngemäß kann dieses Verfahren auch zur Dekodierung für Huffmancodes verwendet werden, die mehr als zwei Werte zusammen codieren.

Bei Codierungen, bei denen der Beginn eines Codewortes nur durch das Ende des vorhergehenden Codewortes bestimmt ist (wie dies beispielsweise beim Huffmancode der Fall ist) führt ein Übertragungsfehler zu einer Fehlerfortpflanzung.

Eine Lösung dieses Problems ist in Anspruch 12 angegeben. Diese Lösung kann selbstverständlich auch unabhängig von anderen Merkmalen eingesetzt werden: Hierzu ordnet man zunächst einen Teil der Codewörter in einem Raster an, dessen Länge beispielsweise größer oder gleich der des längsten Codewortes ist, so kommt es für diesen Teil der Codewörter zu keiner Fehlerfortpflanzung mehr, da ihr Beginn nicht mehr durch das Ende des vorhergehenden Codewortes bestimmt ist. Die restlichen Codewörter werden in die verbleibenden Lücken verteilt. Ein Beispiel hierfür zeigt Figur 2. Wird die verwendete Codetabelle derart aufgebaut, daß man aus den ersten Stellen der Codewörter bereits auf den Bereich der Codetabelle schließen kann, so kann die Länge des verwendeten Rasters auch kleiner als die Länge des längsten Codewortes sein. Die nicht mehr ins Raster passenden Stellen werden wie die restlichen Codewörter in die verbleibenden Lücken verteilt. Durch die Verwendung dieser kürzeren Rasterlänge lassen sich mehr Codewörter in diesem Raster anordnen und die Feherfortpflanzung beschränkt sich auf die letzten Stellen dieser Codewörter, die durch die oben beschriebene Struktur der Codetabelle nur nur von untergeordneter Bedeutung sind. Diese Umsortierung führt zu keiner Verminderung der Codeeffizienz.

Auch dies soll im folgenden anhand Beispiels erläutert werden:

| Wert | Codewort |
| --- | --- |
| 0 | 0 |
| 1 | 100 |
| 2 | 101 |
| 3 | 110 |
| 4 | 111 |

Bereits die ersten beiden Stellen entscheiden, ob der Wert aus dem Bereich "0", "1-2" oder "3-4" ist. Daher wird eine Rasterlänge von 2 gewählt. Es soll folgende Wertefolge codiert übertragen werden:

| Wertefolge | 2 | 0 | 4 | 0 |
| --- | --- | --- | --- | --- |
| Codewörter | 101 | 0 | 111 | 0 |

ohne Codesortierung ergibt ein Bitfehler im ersten Bit die Bitfolge

| | 001 | 0 | 111 | 0 |
| --- | --- | --- | --- | --- |
| zerlegt also | 0 | 0 | 101 | 110 |
| decodiert | 0 | 0 | 2 | 3 |

mit Codesortierung (Rasterlänge 2) ergibt sich folgende Bitfolge

| zunächst | 10 | 0 | 11 | 0 |
| --- | --- | --- | --- | --- |

8

(fortgesetzt)

| Rest | 1 | | 1 | |
|---|---|---|---|---|
| Rest in Lücken | 10 | 0 1 | 11 | 0 1 |

mit einem Bitfehler im ersten Bit ergibt sich die Bitfolge

| | 00 | 01 | 11 | 01 |
|---|---|---|---|---|
| Bereich | 0 | 0 | 3-4 | 0 |

d.h. nur für das gestörte Codewort konnte der Bereich nicht mehr richtig dekodiert werden.

Weiterhin ist auch möglich, wichtige Nachrichtenteile in einem festen Raster anzuordnen:

Die Übertragungssicherheit kontinuierlich aufeinander folgender Nachrichten unterschiedlicher Länge mit Nachrichtenteilen unterschiedlicher Wichtigkeit läßt sich folgendermaßen verbessern: Die mittlere Nachrichtenlänge des kontinuierlichen Bitstromes stellt den Abstand der Punkte eines äquidistanten Rasters dar. Die wichtigen Nachrichtenteile werden nun in diesem festen Raster angeordnet. Zusätzlich wird in diesem wichtigen Informationsteil die Position des zugehörigen weniger wichtigen Teils mit übertragen. Durch den äquidistanten Abstand der wichtigten Information ist im Falle eines Übertragungsfehlers die Neusynchronisation leichter zu erreichen.

Im folgenden soll die Fehlerbegrenzung bei Entropiecodes erläutert werden:

Im Falle eines Bitfehlers im Entropiecode gehen im Fehlerfall in der Regel alle der Fehlerstelle folgenden Informationen verloren. Durch Markierung des Blockanfangs mit einem bestimmten Bitmuster und der zusätzlichen Übertragung der Entropiecodelänge läßt sich der entstehende Fehler auf den Nachrichtenblock, der den Bitfehler enthält, begrenzen. Dies geschieht folgendermaßen:

Nach erfolgreicher Decodierung einer Nachricht müßte der Beginn des nächsten Nachrichtenblocks und damit eine Blockanfangsmarkierung folgen. Ist dies nicht der Fall, wird mit Hilfe der Entropiecodelänge überprüft, ob die Decodierung sich an der nach der Entropiecodelänge zu erwartenden Stelle befindet. Ist dies der Fall, wird ein Fehler in der blockanfangsmarkierung angenommen und korrigiert. Ist dies nicht der Fall, wird geprüft, ob an der durch die Entropiecodelänge angegebene Bitstromposition eine Blockanfangsmarkierung folgt, die dann mit großer Wahrscheinlichkeit den Beginn des nächsten Blocks markiert. Wird keine Blockanfangsmarkierung getroffen liegen mindestens 2 Fehler (Decodierung/Blockanfangsmarkierung oder Entropiecodelänge/Decodierung oder Blockanfangsmarkierung/Entropiecodelänge) vor und es muß neu synchronisiert werden.

Weiterhin ist es möglich, einen Synchronisationsschutz bzw. eine Synchronisationserkennung vorzusehen:

Bei kontinuierlichen Datenströmen, die aus Blöcken unterschiedlicher Länge zusammengesetzt sind, ergibt sich das Problem, daß Synchronwörter zur Kennzeichnung der Blockanfänge sich auch zufällig im Datenstrom befinden können. Die Wahl sehr langer Synchronwörter verringert zwar diese Wahrscheinlichkeit, kann sie aber zum einen nicht zu null setzen und führt zum anderen zu einer Verminderung der Übertragungskapazität. Ein Paar von Schaltungen, das einem gefundenen Synchronwort am Blockanfang eine "1" und innerhalb eines Blockes eine "0" anhängt (bzw. umgekehrt am Blockanfang eine "0" und sonst eine "1"), ist aus der Literatur bekannt (z.B.: intel "BITBUS"-frameformat). Die Anwendung zur Übertragung von codierten Musiksignalen ist erfindungsgemäß. Angepaßt an diese Anwendung enthält die "Synchronisationserkennung" die Möglichkeit, in Bereichen, in denen ein Synchronwort erwartet wird, dieses als solches zu akzeptieren, auch wenn es durch Übertragungsfehler in einigen Stellen verändert wurde.

Im Anspruch 24 ist die Beschränkung der Maximalzahl der Iterationen angegeben:

Ziel ist die Begrenzung der zur Quantisiererkennzeichnung zu übertragenden Bits. Ausgehend von einem Quantisiererstartwert ist nur eine begrenzte Abweichung von diesem Startwert zugelassen, die mit n Bit dargestellt werden kann. Zur Einhaltung dieser Bedingung wird vor jedem Durchgang durch die äußere Schleife geprüft, ob noch gewährleistet ist, daß ein weiter Aufruf der inneren Schleife mit einem gültigen Ergebnis beendet werden kann.

Auch dies soll im folgenden anhand eines Beispiels erläutert werden:

Ausgehend vom Quantisiererstartwert wird der Quantisierer in Stufen von $q = \sqrt[4]{2}$ verändert. Im ungünstigsten Fall werden in der äußeren Schleife alle Frequenzgruppen verstärkt um den Faktor 2. Sind noch 4 Vergröberungen des Quantisierers um $q = \sqrt[4]{2}$ möglich, ist gewährleistet, daß die innere Schleife mit einem in den erlaubten Bitrahmen passenden Ergebnis beendet wird. Zur Übertragung sind für die Abweichung vom Startwert 5 Bit vorgesehen, so daß als Abweichung vom Startwert maximal 31 möglich ist. Die innere Schleife wird also nicht mehr aufgerufen, falls bereits 28 oder mehr erreicht ist, da in diesem Fall nicht mehr sichergestellt ist, daß mit der erlaubten Bitzahl der Block codiert werden kann.

In den Ansprüchen 15 und 16 sind erfindungsgemäße Ausgestaltungen angegeben, die die Psychoakustik dadurch verbessern, daß psychoakustische Maßnahmen über mehrere Blöcke angewendet werden:

Das verwendete, erfindungsgemäße Verfahren soll anhand eines Beispiels beschrieben werden. Um das Beispiel einfach zu halten, sei die Zahl der Frequenzgruppen zu 2 angenommen. Die Werte für die jeweils erlaubte Störung etc. sind ebenfalls Beispielswerte, die in der praktischen Ausführung des Codierverfahrens anders gewählt werden:

Es sei die erlaubte Störung = 0,1 * Signalleistung je Frequenzgruppe. Die Leistungswerte sind ohne Maßangabe angegeben. Der Maßstab kann willkürlich gewählt werden, da nur Verhältnisangaben und nicht der Absolutbetrag der Leistungswerte Verwendung finden.

|  | Frequenzgruppe | Leistung | erlaubte Störung |
|---|---|---|---|
| erster Block: | FG 1: | 50. | 5. |
|  | FG 2: | 60. | 6. |
| zweiter Block: | FG 1: | 1000. | 100. |
|  | FG 2: | 100. | 10. |

Der "Vergessensfaktor", mit dem berücksichtigt wird, daß die Signalleistung des jeweils vorhergehenden Blocks weniger in die Berechnung der aktuell erlaubten Störung eingeht als die Signalleistung des aktuellen Blocks, sei zu 2 gewählt. Die erlaubte Störung im zweiten Block wird dann berechnet als Minimum der aus den Daten des zweiten Blocks errechneten erlaubten Störung und der aus den Daten des ersten Blocks errechneten, korrigiert um den Vergessensfaktor. Es ergibt sich im Beispiel für den zweiten Block für die Frequenzgruppe FG 1:

min(2*6,100)=12 und für FG 2:min (2*5, 10)=10 als erlaubte Störung.

Ferner ist eine "Bitsparkasse" vorgesehen: Im einfachsten Fall wird, wie schon in der WO 88/01811 beschrieben, für jeden Block eine bestimmte Datenrate (Bitzahl) zur Verfügung gestellt. Sofern nicht die gesamte Datenrate zur Codierung des Blockes Verwendung findet, werden die "übriggebliebenen" Bits der für den nächsten Block zur Verfügung stehenden Bitzahl dazugefügt.

In der erfindungsgemäßen Erweiterung dieses Verfahrens werden eine maximale untere und obere Summenabweichung der Datenrate zugelassen. Die Summenabweichung der Datenrate (Abweichung der Bitzahlsummen der Datenblöcke von der aus der gewünschten konstanten Datenrate errechenbaren Bitzahlsumme) wird "Bitsparkasse" genannt.

Die Bitsparkasse wird gefüllt durch die im Normalbetrieb jeweils nicht vollständige Nutzung der aktuell zur Verfügung stehenden Bitzahl. Solange nicht eine obere Grenze der Bitsparkasse (=untere Grenze der Abweichung der Summenbitzahl) erreicht ist, werden jedem Block von neuem nur die aus der mittleren Datenrate errechenbare Bitzahl zur Verfügung gestellt, nicht jedoch die im jeweils vorhergehenden Block "übriggebliebenen" Bits.

Wenn z.B. bei starken Pegelanstiegen des Signals (z.B. Triangel) für einen Datenblock aufgrund der Berücksichtigung der erlaubten Störung des letzten Datenblocks (siehe oben) eine deutlich geringere erlaubte Störung errechnet wird, als dies ohne die Berücksichtigung der Daten des letzten Blocks der Fall wäre, dann werden der inneren Iterationsschleife des aktuellen Blocks mehr Bits zur Codierung zur Verfügung gestellt und der Wert der Summenabweichung ("Bitsparkasse") entsprechend korrigiert. Die Zahl der zusätzlichen Bits wird so gewählt, daß die maximale Summenabweichung ("Mindeststand der Bitsparkasse") nicht überschritten werden kann. Im obigen Beispiel könnte die Zahl der zusätzlichen Bits z.B. wie folgt berechnet werden:

In der ersten Frequenzgruppe des zweiten Blocks wäre die erlaubte Störung = 100., wenn die Daten des ersten Blocks nicht berücksichtig würden. Das Verhältnis zwischen erlaubter Störung mit und ohne Berücksichtigung der Daten des letzten Blockes ist also 100/12 = 8.33, das sind ca. 10*log (8.33) = 9.2dB.

Wenn angenommen wird, daß das Quantisierungsrauschen bei Quantisierung mit einem zusätzlichen Bit pro Wert um ca. 6dB gesenkt wird, dann sind pro Spektralwert der Frequenzgruppe ca. 1,5 bit notwendig, um die geringere erlaubte Störung zu erreichen. Die Zahl der aus der Bitsparkasse zu verwendeten Bits beträgt also im Beispiel 1,5* Zahl der Spektralwerte der Frequenzgruppe.

Anspruch 20 kennzeichnet die Synchronisation von Ausgangs- und Eingangsbittakt:

Bei Codiersystemen mit beliebigem Verhältnis von Eingangs- zu Ausgangsbittakt besteht das Problem, daß die zu vergebende Bitzahl ein unendlicher Bruch sein kann. Damit ist die Synchronisation durch eine Langzeitmittelung der zu vergebenden Bitzahl, die bei einem endlichen Bruch möglich wäre, ausgeschlossen. Ein Auseinanderlaufen von Eingang und Ausgang wird durch eine Regelung verhindert, die den Abstand von Ein- und Ausgabezeiger eines Pufferspreichers beobachtet. Wird der Abstand geringer, wird die Bitzahl verringert und umgekehrt. Bei einem konstanten Verhältnis von Eingangs- zu Ausgangsbittakt bzw. bei einem um einen konstanten Mittelwert variirenden Verhältnis von Eingangs- zu Ausgangsbittakt ist es ausreichend die zu vergebende Bitzahl um jeweils 1 Bit zu variieren. Die maximale Abweichung vom Mittelwert bestimmt jedoch die vorzusehende minimale Puffergröße. Dies soll anhand von Fig. 4 an einer konkreten OCF-Implementierung erläutert werden:

Eingangsdaten sind Abtastwerte, die mit konstanter Frequenz angeliefert werden. Der Ausgang ist an einen Kanal mit konstanter Bitrate angeschlossen. Damit ist ein konstantes mittleres Verhältnis von Eingangs- zu Ausgangsbittakt vorgegeben. Im Coder kann die pro Block an den Ausgang weitergegebene Bitzahl, bedingt durch die Bitsparkasse, schwanken. D.h. es gibt Blöcke für die mehr oder weniger als die durchschnittliche pro Block verfügbare Bitzahl (== Eingangsbittakt/Ausgangsbittakt*Blocklänge), die eine nichtnatürliche Zahl sein kann, an den Ausgang weitergegeben wird. Diese Schwankung wird durch ein FIFO (Ringpuffer) am Ausgang ausgeglichen. Die FIFO-Länge ist entsprechend dem maximalen Inhalt der Bitsparkasse gewählt. Ist die durchschnittliche pro Block verfügbare Bitzahl eine nichtnatürliche Zahl, muß entweder die nächst größere bzw. die nächst kleinere natürliche Bitzahl pro Block vergeben werden. Wird die nächst größere bzw. nächst kleinere gewählt, werden die FIFO-Eingangs- und Ausgangszeiger aufeinanderzulaufen bzw. auseinanderlaufen. Um den Sollabstand werden nun in beide Richtungen Sollabstände definiert, bei deren Überschreiten von nächst größeren zum nächst kleineren (oder umgekehrt) umgeschaltet wird. Dabei wird als Startwert für die zu vergebende Bitzahl eine dieser beiden Näherungen vorgegeben. Bei ausreichender Puffergröße läßt sich diese Regelung auch dazu benützen, diesen Startwert zu ermitteln. Im Zusammenhang mit der Bitsparkasse muß vor dem Pointervergleich der Inhalt der Bitsparkasse berücksichtigt werden.

Wird die Bitzahl um mehr als ein Bit variiert, ist dieses Verfahren auch dann anzuwenden, wenn kein konstanter Mittelwert vorliegt. Aus der Differenz der Pointer wird in diesem Fall die Korrekturbitzahl berechnet.

Die Ansprüche 17 und 18 geben Weiterbildungen an, die u.a. die Nachverdeckung verbessern: Erfindungsgemäß wird zur Berechnung der erlaubten Störung die Signalenergie in den vorhergehenden Datenblöcken einbezogen, indem die erlaubte Störung von einem Datenblock zum nächsten nach Beachtung sämtlicher anderer Parameter zur Bestimmung der aktuellen erlaubten Störung jeweils höchstens um einen bestimmten Faktor abnimmt.

Auch dies soll im folgenden anhand eines Beispiels erläutert werden:

Die erlaubte Störung in der Frequenzgruppe 1 sei im Block 1 gleich 20. Im Block 2 sei die Signalleistung in FG1 gleich 50. Bei einer angenommenen erlaubten Störung von 0,1* Leistung in der Frequenzgruppe wäre die erlaubte Störung gleich 5. Wenn der "Nachverdeckungsfaktor" als -3 dB pro Block angenommen wird, das entspricht einer Halbierung der Leistung, dann wird die erlaubte Störung im Block zu 10(= 0,5 * 20) berechnet.

Ferner ist es möglich, ein Anpassung an verschiedene Bitraten vorzunehmen:

Der Iterationsblock der OCF verteilt die für den Block zur Verfügung stehende Bitzahl entsprechend der Vorgabe der "erlaubten Störung" je Frequenzgruppe. Zur Optimierung des Ergebnisses wird die Berechnung der "erlaubten Störung" der zur Verfügung stehenden Bitzahl angepaßt. Ausgangspunkt ist hierbei die tatsächliche Mithörschwelle, die bei einer "erlaubten Störung" ESO noch nicht verletzt wird. Der für eine bestimmte Bitrate geforderte Störabstand wird so gewählt, daß im Mittel ein gleichmäßiger Verlauf des Störspektrums erreicht wird. Je niedriger die zu vergebende Gesamtbitzahl liegt, umso weniger Störabstand je Gruppe wird gefordert. Dabei wird zwar in einer mit immer niedrigeren Bitraten steigende Anzahl von Blöken die errechnete Mithörschwelle verletzt, doch insgesamt ein gleichmässiger Störverlauf erreicht. Im Gegensatz dazu kann bei höheren Bitraten ein zusätzlicher Sicherheitsabstand zur Mithörschwelle erreicht werden, der z.B. Nachbearbeitung oder Mehrfachcodierung/decodierung des Signals erlaubt.

Als weitere Maßnahme ist eine Bandbreitenbegrenzung durch Löschen bestimmter Frequenzbereiche vor Berechnung der "erlaubten Störung" möglich. Dies kann statisch geschehen oder dynamisch, falls in mehreren Blöcken hintereinander der geforderte Störabstand nur schlecht eingehalten wird.

Bei einem steilem Abfall der Verdeckung zu tiefen Frequenzen hin, d.h. bei der Berechnung der erlaubten Störung ist besonders zu berücksichtigen, daß nur ein geringer Verdekkungseffekt von hohen zu tiefen Frequenzen hin besteht. Die in 1. Näherung berechnete erlaubte Störung wird deshalb, im Falle eines starken Energieanstiegs im Spektrum für die Frequenzgruppen unterhalb des Anstiegs nach unten korrigiert.

Weiterhin wird erfindungsgemäß die Quantisiererkennlinie verbessert:

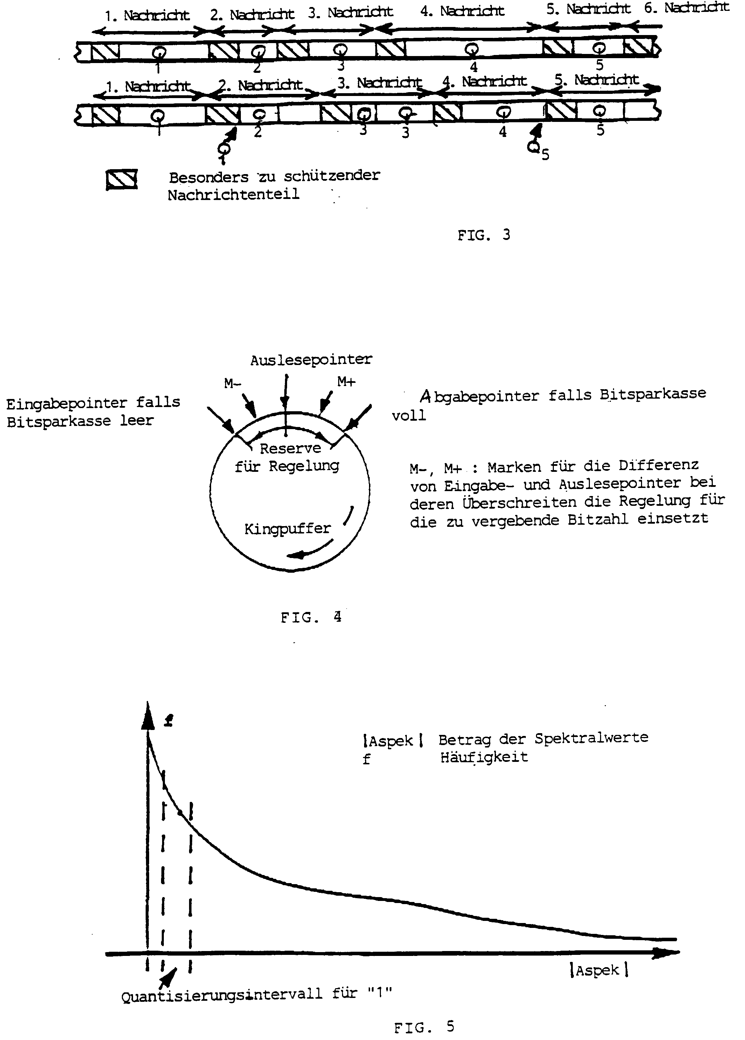

Bei Quantisierung und Rekonstruktion wird die Statistik der unquantisierten Werte beachtet. Diese nimmt in einer gekrümmten Kennlinie streng monoton ab. Dadurch liegt der Erwartungswert jedes Quantisierungsintervalls nicht in der Mitte des Intervalls, sondern näher zu den kleineren Werten verschoben (Fig. 5).

Um den kleinsten Quantisierungsfehler zu erhalten sind zwei Vorgehensweisen möglich:

a) Vorgabe einer Quantisierungskennlinie: Anhand der Quantisierungskennlinie und der statistischen Verteilung der zu quantisierenden Werte wird für jedes Quantisierungsintervall der Erwartungswert bestimmt und als Tabelle für die Rekonstruktion im Decoder verwendet. Der Vorteil dieses Vorgehens liegt in der einfachen Realisierbarkeit und dem geringen Rechenaufwand in Coder und Decoder.

b) Vorgabe der Rekonstruktionskennlinie: Anhand dieser und eines Modells für die Wahrscheinlichkeitsverteilung der Eingangswerte kann eine Quantisiererkennlinie berechnet werden, für die der Erwartungswert jedes Quantisierungsintervalls exakt dem rekonstruiertem Wert dieses Intervalls entspricht. Dies bietet den Vorteil, daß im Decoder keine Tabellen benötigt werden und die Quantisierungskennlinie im Coder an die aktuelle Statistik angepaßt werden kann, ohne daß dies dem Decoder mitgeteilt werden muß.

c) Vorgabe einer Quantisiererkennlinie und Berechnung der Rekonstruktionskennlinie für jeden Wert: Bei gegebener Quantisiererkennlinie und einer Funktion für die Wahrscheinlichkeitsverteilung für die Eingangsdaten kann der Decoder aus diesen jeweils den Rekonstruktionswert berechnen. Dies bietet den Vorteil, daß im Decoder keine Tabellen zur Rekonstruktion benötigt werden. Nachteil dieses Vorgehens ist der höhere Rechenaufwand im Decoder.

**Patentansprüche**

1. Digitales Codierverfahren für die Übertragung und/oder Speicherung von akustischen Signalen und insbesondere von Musiksignalen, bei dem Abtastwerte des akustischen Signals mittels einer Transformation oder einer Filterbank in eine Folge von zweiten Abtastwerten transformiert werden, die die spektrale Zusammensetzung des akustischen Signals wiedergeben, und diese Folge von zweiten Abtastwerten entsprechend den Anforderungen mit unterschiedlicher Genauigkeit quantisiert und teilweise oder ganz mittels eines Codierers codiert wird, bei dem die Auftrittswahrscheinlichkeit des quantisierten Spektralkoeffizienten mit der Länge des Codes derart korreliert ist, daß das Codewort umso kürzer ist, je häufiger der Spektralkoeffizient auftritt, und bei dem bei der Wiedergabe eine entsprechende Decodierung und Rücktransformation erfolgt,
dadurch **gekennzeichnet,**

daß zur Reduzierung der Tabellengröße des Codierers entweder mehreren Elementen der Folge oder einem Wertebereich ein Codewort sowie gegebenenfalls ein Zusatzcode zugeordnet werden, und
daß n Spektralkoeffizienten mit n≥2 zu einem n-Tupel zusammengefaßt und gemeinsam durch Angabe eines Codewortes codiert werden.

2. Codierverfahren nach Anspruch 1,
dadurch **gekennzeichnet,** daß nur einem Teil des Wertebereichs eines Folgen-Elements direkt ein Codewort zugewiesen wird, und daß allen außerhalb dieses Teilbereichs liegenden Werten eine gemeinsame Kennung sowie ein besonderer Code zugewiesen wird.

3. Codierverfahren nach Anspruch 1 oder 2,
dadurch **gekennzeichnet**, daß als Codierer ein Huffmancode verwendet wird.

4. Codierverfahren nach einem der Ansprüche 1 bis 3,
dadurch **gekennzeichnet,** daß der besondere Code ein PCM-Code ist.

5. Codierverfahren nach einem der Ansprüche 1 bis 4,
dadurch **gekennzeichnet,** daß Spektralkoeffizienten insbesondere gleicher Nummer aus wenigstens zwei aufeinanderfolgenden Blöcken zu einem Paar bzw. einem n-Tupel zusammengefaßt und gemeinsam durch Angabe eines Codeworts codiert werden.

6. Codierverfahren nach einem der Ansprüche 1 bis 5, das entsprechend dem OCF-Verfahren arbeitet,
dadurch **gekennzeichnet,** daß aus den Werten für die Anzahl der durchgeführten Iterationschritte, für die Anfangsquantisierungsstufenhöhe, dem Wert für die Ungleichmäßigkeit des Verlaufs des Spektrums sowie weitere Pegelinformatioen aus dem Gang der Berechnung ein Gesamtverstärkungsfaktor berechnet wird, der als Zusatzinformation statt der Einzelwerte zum Empfänger übertragen wird.

7. Codierverfahren nach einem der Ansprüche 1 bis 6,
dadurch **gekennzeichnet,** daß die Zusatz information über Änderungen der Quantisierungsstufe zur Einhaltung der "erlaubten Störung" über mehr als einen Block gemeinsam gebildet und übertragen wird.

8. Codierverfahren nach Anspruch 6 oder 7,
dadurch **gekennzeichnet,** daß die Codierung der Zusatzinformation durch einen Code mit variabler Wortlänge erfolgt.

9. Codierverfahren nach einem der Ansprüche 1 bis 8,
dadurch **gekennzeichnet,** daß signalabhängig unterschiedliche Codetabellen verwendet werden, und daß zusammen mit den codierten Werten die Nummer der verwendeten Codetabelle übertragen bzw. gespeichert wird.

**10.** Codierverfahren nach Anspruch 9,
dadurch **gekennzeichnet,** daß für verschiedene Spektralbereiche unterschiedliche Codetabellen verwendet werden, und daß die Grenzen zwischen den Bereichen fest vorgegeben sind oder signalabhängig ermittelt werden.

**11.** Codierverfahren nach einem der Ansprüche 1 bis 10,
dadurch **gekennzeichnet,** daß zur Decodierung eine Tabelle verwendet wird, in der Wertepaare gespeichert sind, von denen der erste Wert des Paares jeweils die Adresse enthält, die im Falle einer "0" im zu dekodierenden Wert anzuspringen ist, und der zweite Wert des Paares die Adresse im Falle einer "1", und daß Tabellenwerte ohne Adreßangabe das Codewort bezeichnen.

**12.** Codierverfahren nach einem der Ansprüche 1 bis 11,
dadurch **gekennzeichnet,** daß ein Teil der Codewörter variabler Länge in einem Raster angeordnet wird, und daß die restlichen Codewörter in die verbleibenden Lücken verteilt werden, so daß ohne vollständige Decodierung oder bei fehlerhafter Übertragung der Anfang eines Codeworts leichter gefunden werden kann.

**13.** Codierverfahren nach Anspruche 12,
dadurch **gekennzeichnet,** daß zur Verbesserung der Übertragungssicherheit kontinuierlich aufeinanderfolgender Nachrichten mit unterschiedlicher Wichtigkeit ein äquidistantes Raster vorgegeben wird, dessen Rasterlänge der mittleren Länge der zu übertragenden Nachrichten entspricht, und daß die wichtigsten Nachrichtenteile in diesem Raster angeordnet werden, und daß ggflls. zusätzlich zu den wichtigsten Nachrichtenteilen in diesem Raster die Position der weniger wichtigen Nachrichten übertragen wird.

**14.** Codierverfahren nach einem der Ansprüche 1 bis 13,
dadurch **gekennzeichnet,** daß zur Ermittlung des Beginns des nächsten Nachrichtenblocks im Falle eines Übertragungsfehlers ein Blockanfangsmarkierung und zusätzlich die Entropiecodelänge übertragen werden.

**15.** Codierverfahren nach einem der Ansprüche 1 bis 14,
dadurch **gekennzeichnet,** daß für die Berechnung der "erlaubten Störung" eines Datenblockes längere Signalabschnitte verwendet als in einem Block codiert werden, oder die Berechnungsvorschrift von den Ergebnissen vorheriger Zeitabschnitte abhängig ist.

**16.** Codierverfahren nach Anspruch 15,
dadurch **gekennzeichnet,** daß zur Berechnung der "erlaubten Störung" für einen Datenblock eine Analyse der Signalenergie in den verschiedenen Frequenzgruppen durchgeführt wird, und daß jeweils die Werte des vorhergehenden Blocks, die um einen "Vergessens-Faktor" korrigiert sind, sowie die Werte des aktuellen Blocks gemeinsam zur Berechnung der "erlaubten Störung" herangezogen werden.

**17.** Codierverfahren nach Anspruch 15 oder 16,
dadurch **gekennzeichnet,** daß zur Berechnung der "erlaubten Störung" für einen Datenblock die Energiewerte des letzten Datenblocks in der Weise Verwendung finden, daß Werte geringer Amplitude, die auf Wert höherer Amplitude folgen, weniger genau quantisiert werden müssen.

**18.** Codierverfahren nach einem der Ansprüche 15 bis 17,
dadurch **gekennzeichnet,** daß die errechnete erlaubte Störung bei Detektierung eines steilen Energieanstiegs zu hohen Frequenzen hin für die Frequenzgruppe unterhalb des Anstiegs verringert wird.

**19.** Codierverfahren nach einem der Ansprüche 1 bis 18,
dadurch **gekennzeichnet,** daß zwar im Mittel eine konstante Datenrate eingehalten wird, daß aber die einem Block zur Verfügung gestellte oder von dem Block beanspruchte Bitanzahl abhängig von den Signaleigenschaften, der Kapazität des Übertragungskanals oder zur Vereinfachung der Codierung von der durchschnittlichen Datenrate abweichen kann.

**20.** Codierverfahren nach Anspruche 19,
dadurch **gekennzeichnet,** daß zur Synchronisation von Codierverfahren mit beliebigem Verhältnis von Eingangs- und Ausgangsbittakt, der "Füllstand" eines mit einem Ausgangsbit-Takt ausgelesenen Puffers als Regelgröße für die zu vergebende Bitzahl dient.

**21.** Codierverfahren nach Anspruch 19 oder 20,

dadurch **gekennzeichnet,** daß die Zahl zur Codierung eines Datenblocks zur Verfügung stehenden Bits in Abhängigkeit von den Signaleigenschaften so geändert wird,

daß einerseits im Mittel eine konstante Datenrate eingehalten wird, und die Summenabweichung von diesem Mittelwert nicht höher als ein bestimmter vorher festgesetzter Wert sowie nicht geringer als ein anderer vorher festgesetzter Wert ist, und
daß andererseits Signalblöcken mit größerem Abstand zwischen Signalleistung in den einzelnen Frequenzgruppen unter jeweiligen "erlaubten Störung" eine größere aktuelle Datenrate "zur Verfügung stehende Bitzahl" zugeteilt wird als Signalblöcken mit einem geringerem Abstand.

22. Codierverfahren nach einem der Ansprüche 19 bis 21,
dadurch **gekennzeichnet,** daß von den für einen Block zur Verfügung stehenden Bits die Anzahl der von den Zusatzdaten benötigten Bits, die auf dem selben Kanal übertragen werden, abgezogen werden.

23. Codierverfahren nach einem der Ansprüche 19 bis 22,
dadurch **gekennzeichnet,** daß bei Verwendung einer besonderen Bitkombination für ein Synchronwort zur Blocksynchronisation das Synchronwort und alle zufällig mit dem Synchronwort identischen Bitkombinationen mit einem bewußt eingefügten zusätzlichen Bit voneinander unterschieden werden.

24. Codierverfahren nach einem der Ansprüche 19 bis 23,
dadurch **gekennzeichnet,** daß die äußere Iterationsschleife abgebrochen wird, falls die innere Schleife innerhalb der maximalen Iterationszahl nicht sicher beendet werden kann.

25. Codierverfahren nach einem der Ansprüche 1 bis 24,
dadurch **gekennzeichnet,** daß Bereiche, in denen die "erlaubte Störung" größer als die Signalenergie ist, gelöscht werden.

26. Codierverfahren nach einem der Ansprüche 1 bis 25,
dadurch **gekennzeichnet,** daß die entstehende Folge von gelöschten Werten durch ein Bit in der Seiteninformation codiert wird.

27. Codierverfahren nach einem der Ansprüche 1 bis 26,
dadurch **gekennzeichnet,** daß die entstehende Folge von gelöschten Werten durch einen Wert in der Tabelle der möglichen Quantisierungsstufenhöhen für jede Frequenzgruppe in der Seiteninformation codiert wird.

28. Codierverfahren nach einem der Ansprüche 1 bis 27,
dadurch **gekennzeichnet,** daß die Quantisierung und Rekonstruktion so aneinander angepaßt sind, daß der Quantisierungsfehler im Mittel minimal wird.

29. Codierverfahren nach einem der Ansprüche 1 bis 28,
dadurch **gekennzeichnet,** daß die Berechnung der rekonstruierten Werte im Empfänger mittels einer Tabelle geschieht, die durch Ermittlung der tatsächlichen Erwartungswerte der Eingangswerte eines Quantisierungsintervalls erstellt wurde.

30. Codierverfahren nach einem der Ansprüche 1 bis 29,
dadurch **gekennzeichnet** daß die Quantisierung über eine Tabelle geschieht, die aus der Rekonstruktionskennlinie und der Wahrscheinlichkeitsverteilung der Eingangsdaten berechnet wird.

31. Codierverfahren nach einem der Ansprüche 1 bis 30,
dadurch **gekennzeichnet,** daß zur Rekonstruktion mittels der Quantisierungskennlinie und der Wahrscheinlichkeitsverteilung der Eingangsdaten im Decoder für jeden einzelnen quantisierten Wert der Rekonstruktionswert so berechnet wird, daß der Quantisierungsfehler minimal wird.

32. Decodierverfahren zur Decodierung der nach dem digitalen Codierverfahren gemäß Anspruch 1 codierten Signale, bei dem bei der Wiedergabe eine der Codierung nach Anspruch 1 entsprechende Decodierung und Rücktransformation erfolgt.

33. Decodierverfahren nach Anspruch 32,

dadurch **gekennzeichnet,** daß eine Tabelle verwendet wird, in der Wertepaare gespeichert sind, von denen der erste Wert des Paares jeweils die Adresse enthält, die im Falle einer "0" im zu dekodierenden Wert anzuspringen ist, und der zweite Wert des Paares die Adresse im Falle einer "1", und daß Tabellenwerte ohne Adreßangabe das Codewort bezeichnen.

34. Decodierverfahren nach Anspruch 32 oder 33,
dadurch **gekennzeichnet,** daß ein Raster verwendet wird, in dem ein Teil der Codewörter variabler Länge angeordnet ist, und daß die restlichen Codewörter in die verbleibenden Lücken verteilt werden, so daß ohne vollständige Decodierung oder bei fehlerhafter Übertragung der Anfang eines Codeworts leichter aufgefunden wird.

35. Decodierverfahren nach einem der Ansprüche 32 bis 34,
dadurch **gekennzeichnet,** daß zur Berechnung der rekonstruierten Werte eine Tabelle verwendet wird, die durch Ermittlung tatsächlicher Erwartungswerte der Eingangswerte eines Quantisierungsintervall erstellt wird.

## Claims

1. Digital coding method for transmitting and/or storing audio signals, particularly music signals, wherein the sampled values of the audio signal are transformed by means of a transformation or a filter array into a string of second sampled values representing the spectral composition of said audio signal, and wherein this string of second sampled values is quantized and coded, either partly or completely, by means of an encoder in which the probability of occurrence of said quantized spectral coefficient is so correlated with the length of the code that the code word is the shorter the more frequently occurs the spectral coefficient, and wherein appropriate decoding and re-transformation are performed during reproduction,
**characterized** in

that a code word as well as an additional code, if necessary, are associated with several elements of said string or with a range of values so as to reduce the size of the table of said encoder, and
that $n$ spectral coefficients, with $n \geq 2$, are combined to form an $n$-tuple and are jointly coded by the specification of a code word.

2. Coding method according to Claim 1,
**characterized** in that a code word is directly assigned only to one segment of said range of values of a string element, and that a joint identifier as well as a special code are assigned to all values outside this sub-range.

3. Coding method according to Claim 1 or 2,
**characterized** in that a Huffman code is used as encoder.

4. Coding method according to any of Claims 1 to 3,
**characterized** in that said special code is a PCM code.

5. Coding method according to any of Claims 1 to 4,
**characterized** in that spectral coefficients, particularly of the same number from at least two successive blocks, are combined to form a pair or an $n$-tuple, respectively, and are jointly coded by the specification of a code word.

6. Coding method according to any of Claims 1 to 5, which operates in correspondence with the OCF method,
**characterized** in that a total gain is computed from the values of the number of iterating steps performed, of the initial value of the quantizing level, the value of the inhomogeneity of the spectrum pattern as well as further level information based on the arithmetic operation, which total gain is transmitted to the receiver as additional information instead of the individual values,

7. Coding method according to any of Claims 1 to 6,
**characterized** in that said additional information about changes of the quantizing level for compliance with the "permissible noise" is jointly formed over more than one block and transmitted.

8. Coding method according to Claim 6 or 7,
**characterized** in that said additional information is coded by means of a code having a variable word length.

9. Coding method according to any of Claims 1 to 8,
**characterized** in that different coding tables are used as a function of the signal, and
that the number of the used coding table is transmitted or stored, respectively, jointly with the coded values.

10. Coding method according to Claim 9,
**characterized** in that different coding tables are used for different spectral ranges, and that the boundaries between the ranges are invariably specified or determined as a function of the signal.

11. Coding method according to any of Claims 1 to 10,
**characterized** in that for decoding a table is used which stores pairs of values whereof the first value of the pair contains the respective address which is the branch destination in the event of a "0" in the value to be decoded, and whereof the second value of the pair is the address in the event of a "1", and
that table values without designation of an address designate the code word.

12. Coding method according to any of Claims 1 to 11,
**characterized** in that one part of said code words of variable length is arranged within a raster pattern, and
that the remaining code words are distributed into the remaining gaps so as to facilitate the finding of the beginning of a code word without complete decoding or in the event of a fault in transmission.

13. Coding method according to Claim 12,
**characterized** in that an equidistant raster pattern is predetermined for improving the reliability in transmission of messages of different importance in continuous succession, which raster pattern has a length corresponding to the mean length of the messages to be transmitted, and
that the most important message segments are disposed in said raster pattern, and that possibly the position of the less important messages is transmitted in this raster pattern in addition to said most important message segments.

14. Coding method according to any of Claims 1 to 13,
**characterized** in a block start marker and additionally the entropy code length are transmitted for determining the beginning of the next message block in the event of a fault in transmission.

15. Coding method according to any of Claims 1 to 14,
**characterized** in that for the computation of the "permissible noise" of a data block signal segments are used which are longer than those encoded in one block, or that the rule of computation depends on the results of previous intervals.

16. Coding method according to Claim 15,
**characterized** in that for the computation of the "permissible noise" for one data block the signal energy is analyzed in various frequency groups, and that the respective values of the preceding block, which are corrected by a "forget factor" as well as the values of the actual block are jointly referred to for computing the "permissible noise".

17. Coding method according to Claim 15 or 16,
**characterized** in that for the computation of the "permissible noise" for one data block the energy values of the last data block are used in a way that low-amplitude values, which follow values of a higher amplitude, need to be quantized with a reduced precision.

18. Coding method according to any of Claims 15 to 17,
**characterized** in that the computed permissible noise is reduced when a steep energy increase towards high frequencies is detected for the frequency group below the increase.

19. Coding method according to any of Claims 1 to 18,
**characterized** in that even though a constant data rate is observed on average the number of bits made available for one block or seized by the block may be at variance from the average data rate in correspondence with the signal characteristics, the capacity of the transmission channel, or for a simplification of the coding operation.

20. Coding method according to Claim 19,
**characterized** in that the "filling level" of a buffer read at an output bit rate serves as control variable for the bit number to be assigned, so as to synchronize coding methods involving an optional ratio of input bit rate to output bit rate.

21. Coding method according to Claim 19 or 20,
**characterized** in that the number of bits available for coding a data block is varied in response to the signal characteristics such

that, on the one hand, a mean constant data rate will be observed and the cumulative variation from this mean value will not exceed a certain previously determined value and will not drop below another previously determined value, and

that, on the other hand, an actual data rate of the "number of bits available" is assigned to signal blocks presenting a greater ratio between the signal power in the individual frequency groups and the respective "permissible noise", which data rate is greater than the one assigned to signal blocks presenting a smaller ratio.

22. Coding method according to any of Claims 19 to 21,
**characterized** in that the number of the bits required by additional data, which are transmitted on the same channel, is deducted from the number of bits available for one block.

23. Coding method according to any of Claims 19 to 22,
**characterized** in that when a special bit combination is used for a sync word for block synchronization the sync word and all bit combinations accidentally identical with this sync word are discriminated by an intentionally inserted additional bit.

24. Coding method according to any of Claims 19 to 23,
**characterized** in that the exterior iteration loop is aborted if the interior loop cannot be safely terminated within the maximum number of iterations.

25. Coding method according to any of Claims 1 to 24,
**characterized** in that spheres where the "permissible noise" exceeds the signal energy are deleted.

26. Coding method according to any of Claims 1 to 25,
**characterized** in that the resulting succession of deleted values is coded with a bit in the side information.

27. Coding method according to any of Claims 1 to 25,
**characterized** in that the resulting succession of deleted values is coded by a value in the table of possible quantization level values for each frequency group in the side information.

28. Coding method according to any of Claims 1 to 27,
**characterized** in that the quantization and reconstruction are matched with each other so as to minimize the mean quantization error.

29. Coding method according to any of Claims 1 to 28,
**characterized** in that the reconstructed values are computed in the receiver by means of a table which was compiled by determining the actual values expected for the initial values of a quantization interval.

30. Coding method according to any of Claims 1 to 29,
**characterized** in that quantization is realized via a table which is computed from the reconstruction characteristic and from the probability distribution of the input data.

31. Coding method according to any of Claims 1 to 30,
**characterized** in that for a reconstruction by means of said quantization characteristic and the probability distribution of the input data in the decoder, the reconstructed value is computed for each quantized value so as to minimize the quantization error.

32. Decoding method for decoding the signals encoded in the digital coding method according to Claim 1, wherein during reproduction decoding and re-transformation are performed in correspondence with decoding according to Claim 1.

33. Decoding method according to Claim 32,

**characterized** in that a table is used which stores pairs of values whereof the first value of the pair contains the respective address which is the branch destination in the event of a "0" in the value to be decoded, and whereof the second value of the pair is the address in the event of a "1", and that table values without a designation of an address designate the code word.

34. Decoding method according to Claim 32 or 33,
**characterized** in that a raster pattern is used where one part of said code words of variable length is arranged, and that the remaining code words are distributed into the remaining gaps so as to facilitate the finding of the beginning of a code word without complete decoding or in the event of a fault in transmission.

35. Decoding method according to any of Claims 32 to 34,
**characterized** in that for the computation of the reconstructed values a table is used which is compiled by determining the actual values expected for the initial values of a quantization interval.

**Revendications**

1. Procédé de codage numérique pour la transmission et/ou la mise en mémoire des signaux audio, en particulier des signaux de musique, dans lequel des valeurs balayées du signal audio sont transformées moyennant un étage transformateur ou un système à filtres, dans une suite de deuxièmes valeurs balayées, qui représentent la composition spectrale dudit signal audio, et cette suite de deuxièmes valeurs balayées est quantifiée et codée, en partie ou complètement, aux niveaux de précision différents selon les exigences, moyennant un codeur où une correlation est établie entre la probabilité d'apparition du coefficient spectral quantifié et la longueur du code, de façon que le mot code devienne le plus court, le plus fréquemment apparaît le coefficient spectral, et où au temps de reproduction, on réalise un décodage et une re-transformation appropriés,
**caractérisé** en ce

qu'un mot code, ainsi qu'éventuellement un code supplémentaire, sont affectés soit à plusieurs éléments de la suite, soit à une gamme de valeurs, afin de réduire la grandeur d'une table du codeur, et en ce que $n$ coefficients spectraux, à $n \geq 2$, sont combinés de façon à former un $n$-tuple et sont codés ensemble par l'indication d'un mot code.

2. Procédé de codage selon la revendication 1,
**caractérisé** en ce qu'un mot code est directement mise en relation avec une partie seulement de la gamme de valeurs d'un élément de la suite, et en ce qu'un indice d'identification ainsi qu'un code particulier sont affectés à toutes les valeurs en dehors de cette gamme partielle.

3. Procédé de codage selon la revendication 1 ou 2,
**caractérisé** en ce qu'un code d'Huffman est utilisé en tant que codeur.

4. Procédé de codage selon une quelconque des revendications 1 à 3,
**caractérisé** en ce que ledit code particulier est un code PCM.

5. Procédé de codage selon une quelconque des revendications 1 à 4,
**caractérisé** en ce que des coefficients spectraux, en particulier du même nombre d'au moins deux blocs successifs, sont combinés de façon à former une paire ou respectivement un $n$-tuple, et sont codés ensemble par l'indication d'un mot code.

6. Procédé de codage selon la une quelconque des revendications 1 à 5, qui fonctionne à la base de la technique OCF,
**caractérisé** en ce qu'un facteur d'amplification total est calculé, qui est transmis au récepteur comme information supplémentaire, au lieu des valeurs individuelles, le calcul se faisant par dérivation des valeurs du nombre des pas itératifs réalisés, de la valeur initiale du niveau de quantification, de la valeur de la variation de l'allure du spectre, ainsi que des autres informations de niveau à la base de l'opération arithmétique.

7. Procédé de codage selon une quelconque des revendications 1 à 6,
**caractérisé** en ce que ladite information supplémentaire sur le niveau de quantification pour l'observation du "bruit permis" surplus qu'un seul bloc est formée et transmise en commun.

**8.** Procédé de codage selon la revendication 6 or 7,
**caractérisé** en ce que le codage de ladite information supplémentaire se fait moyennant un code à une longueur du mot variable.

**9.** Procédé de codage selon une quelconque des revendications 1 à 8,
**caractérisé** en ce que des tables de codage différentes sont utilisées en fonction du signal, et en ce que le nombre de la table de codage utilisée, ensemble avec les valeurs codées, est transmise ou respectivement mise en mémoire.

**10.** Procédé de codage selon la revendication 9,
**caractérisé** en ce que des tables de codage différentes sont utilisées pour des gammes spectrales différentes, et en ce que les limites entre les gammes sont invariablement prédéterminées ou sont déterminées en fonction du signal.

**11.** Procédé de codage selon une quelconque des revendications 1 à 10,
**caractérisé** en ce qu'une table est utilisée pour le décodage, où des paires de valeurs sont mises en mémoire, dont la première valeur de la paire contient l'adresse respective comme l'adresse de transfert au cas de la présence de "0" dans la valeur à décoder, et dont la deuxième valeur de la paire est l'adresse au cas de la présence de "1", et en ce que des valeurs dans la table sans indication de l'adresse indiquent le mot code .

**12.** Procédé de codage selon une quelconque des revendications 1 à 11,
**caractérisé** en ce qu'une partie desdits mots codes à longueur variable est arrangée au dedans d'une trame, et en ce que les mots codes restants sont répartis dans les interstices restants, afin de faciliter la découverte du début d'un mot code, sans décodage complet, ou au cas d'une erreur en transmission.

**13.** Procédé de codage selon la revendication 12,
**caractérisé** en ce qu'une trame équidistante est prédéterminée afin d'améliorer la fiabilité en transmission d'informations à importance différente en suite continue, ladite trame ayant une longueur qui correspond à la longueur moyenne des informations à transmettre, et en ce que les segments d'information les plus importants sont arrangés dans ladite trame, et en ce qu'éventuellement la position des informations de moindre importance est transmise dans cette trame, au surplus auxdits segments d'information les plus importants.

**14.** Procédé de codage selon une quelconque des revendications 1 à 13,
**caractérisé** en ce qu'un indicateur de début de bloc et de plus la longueur de code d'entropie sont transmis afin d'indiquer le début du prochain bloc d'information au cas d'une erreur en transmission.

**15.** Procédé de codage selon une quelconque des revendications 1 à 14,
**caractérisé** en ce que des segments de signal sont utilisés pour le calcul du "bruit permis" d'un bloc de données, qui sont plus longues que les segments codés dans un bloc, ou que la règle de calcul dépend des résultats calculés dans des intervalles précédants.

**16.** Procédé de codage selon la revendication 15,
**caractérisé** en ce que pour le calcul du "bruit permis" pour un bloc de données, l'énergie du signal est analysée dans plusieurs groupes de fréquences, et en ce qu'on fait référence commune aux valeurs respectives du bloc précédant, qui sont corrigées par un "facteur d'oubli", ainsi qu'aux valeurs du bloc actuel en commun, pour le calcul du "bruit permis".

**17.** Procédé de codage selon la revendication 15 ou 16,
**caractérisé** en ce que pour le calcul du "bruit permis" pour un bloc de données, les valeurs de l'énergie du dernier bloc de données sont utilisées de façon que des valeurs à petite amplitude, qui suivent des valeurs à une plus grande amplitude, soient à quantifier à une précision réduite.

**18.** Procédé de codage selon une quelconque des revendications 15 à 17,
**caractérisé** en ce que le bruit permis calculé est réduit quand une croissance raide vers des hautes fréquences est détectée pour la groupe de fréquences au dessous de cette croissance.

**19.** Procédé de codage selon une quelconque des revendications 1 à 18,
**caractérisé** en ce que, même quand un débit binaire constant est observé en moyenne, le nombre de bits disponibles pour un bloc pris par le bloc peut varier du débit binaire moyen en fonction des caractéristiques du signal, de la capacité de la voie de transmission, ou afin de faciliter l'opération de codage.

**20.** Procédé de codage selon la revendication 19,
**caractérisé** en ce qu'un "niveau de remplissage" d'un tampon lu à un débit binaire de sortie, sert comme variable commandée pour le nombre de bits à affecter, afin de synchroniser des techniques de codage qui opèrent à la base d'un rapport quelconque entre le débit binaire d'entrée et le débit binaire de sortie.

**21.** Procédé de codage selon la revendication 19 ou 20,
**caractérisé** en ce que le nombre de bits disponible pour le codage d'un bloc de données est varié en réponse aux caractéristiques du signal, de façon que

d'un côté, un débit binaire constant moyen soit observé, et la variation accumulée de cette valeur moyenne n'excède pas une valeur définie, déterminée au préalable, et ne tombe pas au dessous d'une autre valeur déterminée au préalable, et
que, d'autre côté, un débit binaire actuel du "nombre de bits disponible" soit affecté à ceux blocs de signaux, dont le rapport entre l'énergie du signal et le "bruit permis" respectif est plus grand, le débit binaire en affecté étant plus grand que le débit affecté aux blocs de signaux, dont ce rapport est plus petit.

**22.** Procédé de codage selon une quelconque des revendications 19 à 21,
**caractérisé** en ce qu'un nombre de bits requis par les données supplémentaires, qui sont transmises par la même voie, est soustrait du nombre de bits disponibles pour un bloc.

**23.** Procédé de codage selon une quelconque des revendications 19 à 22,
**caractérisé** en ce qu'au cas, où une combinaison de bits particulières est utilisée pour un mot de synchronisation pour une synchronisation du bloc, ce mot de synchronisation et tous les combinaisons binaires par 'hasard identiques à ce mot de synchronisation sont discriminés par un bit supplémentaire qui est inséré de propos délibéré.

**24.** Procédé de codage selon une quelconque des revendications 19 à 23,
**caractérisé** en ce que la boucle d'itération extérieure est tronquée si la boucle intérieure ne peut pas être finie de façon sûre avant la fin du nombre maximal des pas itératifs.

**25.** Procédé de codage selon une quelconque des revendications 1 à 24,
**caractérisé** en ce que des gammes, où le "bruit permis" est plus grand que l'énergie du signal, sont effacées.

**26.** Procédé de codage selon une quelconque des revendications 1 à 25,
**caractérisé** en ce que la suite résultante de valeurs effacées est codée moyennant un bit dans l'information de côté.

**27.** Procédé de codage selon une quelconque des revendications 1 à 26,
**caractérisé** en ce que la suite résultante de valeurs effacées est codée avec la valeur dans la table de valeurs des niveaux de quantification pour chaque groupe de fréquences dans l'information de côté.

**28.** Procédé de codage selon une quelconque des revendications 1 à 27,
**caractérisé** en ce que la quantification et la restitution sont accordées l'une à l'autre de façon à minimiser l'erreur moyenne en quantification.

**29.** Procédé de codage selon une quelconque des revendications 1 à 28,
**caractérisé** en ce que les valeurs restituées sont calculées dans le récepteur moyennant une table composée par la détermination des valeurs actuelles attendues pour les valeurs initiales d'un intervalle de quantification.

**30.** Procédé de codage selon une quelconque des revendications 1 à 29,
**caractérisé** en ce que la quantification se fait via une table qui est calculée à la base de la caractéristique de restitution et de la répartition de la probabilité des données d'entrée.

**31.** Procédé de codage selon une quelconque des revendications 1 à 30,
**caractérisé** en ce que pour chaque valeur quantifiée, la valeur restituée est calculée afin de minimiser l'erreur en quantification, pour une restitution moyennant ladite caractéristique de quantification et de la répartition de la probabilité des donnés d'entrée dans le décodeur.

32. Procédé de décodage des signaux codés selon la procédé de codage numérique selon la revendication 1, dans lequel au cours de la reproduction il y a un décodage et une re-transformation en correspondance avec le codage selon la revendication 1.

33. Procédé de décodage selon la revendication 32,
**caractérisé** en ce qu'une table est utilisée pour le décodage, où des paires de valeurs sont mises en mémoire, dont la première valeur de la paire contient l'adresse respective comme l'adresse de transfert au cas de la présence de "0" dans la valeur à décoder, et dont la deuxième valeur de la paire est l'adresse au cas de la présence de "1", et en ce
que des valeurs dans la table sans indication de l'adresse indiquent le mot code .

34. Procédé de décodage selon la revendication 32 ou 33,
**caractérisé** en ce qu'une trame est utilisée, où une partie desdits mots codes à longueur variable est arrangée, et en ce
que les mots codes restants sont répartis dans les interstices restants, afin de faciliter la découverte du début d'un mot code, sans décodage complet, ou au cas d'une erreur en transmission.

35. Procédé de décodage selon une quelconque des revendications 32 à 34,
**caractérisé** en ce que pour le calcul des valeurs restituées on utilise une table qui est établie par la détermination des valeurs attendues actuelles des valeurs d'entrée d'un intervalle de quantification.

EP 0 612 156 B1

FIG. 1

|ẋ|   Betrag der quantisierten Werte
f     Frequenz

FIG. 2

Gesamtlänge des zu einer Nachricht gehörenden Entropiecodes N

Synchronstellen

1. Wort

1. Rest

größtmögliche Einzelwortlänge = Synchronisationsrahmen

1. bis N/Z, Wort der Nachricht, beginnend jeweils nach der Länge des längstmöglichen Wortes

Pro Synchronisationsrahmen verbleibender Rest der nach Vergabe der Plätze mit definiertem Beginn mit den noch übrigen Bit aufgefüllt wird

"Überstehende" Bit, die im 1. Rest angeordnet werden

22

1. Nachricht  2. Nachricht  3. Nachricht  4. Nachricht  5. Nachricht  6. Nachricht

1. Nachricht  2. Nachricht  3. Nachricht  4. Nachricht  5. Nachricht

Besonders zu schützender Nachrichtenteil

FIG. 3

Auslesepointer

M−    M+

Eingabepointer falls Bitsparkasse leer

Abgabepointer falls Bitsparkasse voll

Reserve für Regelung

Kingpuffer

M−, M+ : Marken für die Differenz von Eingabe- und Auslesepointer bei deren Überschreiten die Regelung für die zu vergebende Bitzahl einsetzt

FIG. 4

|Aspek|   Betrag der Spektralwerte
f         Häufigkeit

|Aspek|

Quantisierungsintervall für "1"

FIG. 5